Europäisches Patentamt

European Patent Office

Office européen des brevets

(19)

(11) **EP 0 511 141 B1**

(12) **FASCICULE DE BREVET EUROPEEN**

(45) Date de publication et mention
de la délivrance du brevet:
**11.12.1996 Bulletin 1996/50**

(51) Int Cl.$^6$: **H03M 13/12**, H03M 13/22

(21) Numéro de dépôt: **92460013.3**

(22) Date de dépôt: **22.04.1992**

(54) **Procédé de codage correcteur d'erreurs à au moins deux codages convolutifs systématiques en parallèle, procédé de décodage itératif, module de décodage et décodeur correspondants**

Fehlerkorrekturkodierungsverfahren mit mindestens zwei parallellen, systematischen Faltungsenkodern, iterativem Dekodierungsverfahren, Dekodierungsmodul und Dekoder dafür

Error correction encoding method comprising at least two parallel systematic convolutional encoding, iterative decoding method, decoding module and decoder therefor

(84) Etats contractants désignés:
**DE GB**

(30) Priorité: **23.04.1991 FR 9105280**

(43) Date de publication de la demande:
**28.10.1992 Bulletin 1992/44**

(60) Demande divisionnaire: **96107690.8**

(73) Titulaires:
• **FRANCE TELECOM**
**75015 Paris (FR)**
• **TELEDIFFUSION DE FRANCE SA**
**F-75932 Paris Cédex 15 (FR)**

(72) Inventeur: **Berrou, Claude**
**F-29217 Le Conquet (FR)**

(74) Mandataire: **Corlau, Vincent**
**c/o Cabinet Vidon,**
**Immeuble Germanium,**
**80 avenue des Buttes de Coesmes**
**35700 Rennes (FR)**

(56) Documents cités:
**EP-A- 0 235 477**     **FR-A- 2 616 986**
**US-A- 3 652 998**     **US-A- 4 677 625**
**US-A- 4 677 626**

• **ELECTRONICS AND COMMUNICATIONS IN JAPAN vol. 66, no. 4, Avril 1983, SILVER SPRING, MARYLAND, USA pages 20 - 28; NAKANO ET AL: 'NEW DECODING METHODS OF INTERLEAVED BURST ERROR-CORRECTING CODES'**
• **ELECTRONICS LETTERS vol. 25, no. 22, 26 Octobre 1989, STEVENAGE, HETS.,G. pages 1517 - 1518; DUNSCOMBE ET AL: 'OPTIMAL INTERLEAVING SCHEME FOR CONVOLUTION CODING'**
• **COMSAT - TECHNICAL REVIEW vol. 14, no. 2, 1984, WASHINGTON, DC, USA pages 261 - 284; MACKENTHUN: 'BLOCK ORTHOGONAL CONVOLUTIONAL CODING FOR THE INTELSAT TDMA DATA CHANNEL'**
• **ONZIEME COLLOQUE GRETSI 1 Juin 1987, NICE, FR pages 217 - 220; BATTAIL ET AL: 'DECODAGE PONDERE DES CODES CONCATENES AVEC CODE INTERIEUR CONVOLUTIF'**

EP 0 511 141 B1

**Description**

Le domaine de l'invention est celui du codage de données numériques appartenant à une séquence de données source destinée à être transmise, ou diffusée, notamment en présence de bruit de transmission, et du décodage des données codées ainsi transmises.

Plus précisément, l'invention concerne un procédé de codage correcteur d'erreurs, reposant notamment sur une approche totalement nouvelle de la concaténation de plusieurs codes, et un procédé de décodage, permettant la réalisation de décodeurs modulaires, à plusieurs niveaux de qualité en fonction du nombre de modules mis en oeuvre.

L'invention trouve des applications dans tous les cas où il est nécessaire de transmettre des informations numériques avec un certain degré de fiabilité. Un domaine d'application privilégié de l'invention est celui de la transmission numérique sur des canaux très bruités. A titre d'exemple, l'invention peut être mise en oeuvre pour l'émission et la réception de signaux par l'intermédiaire de satellites. Elle peut également avantageusement être utilisée pour les transmissions spatiales vers, ou entre, des vaisseaux spatiaux et/ou des sondes spatiales, et plus généralement dans tous les cas où la fiabilité du décodage est critique. L'invention peut toutefois s'appliquer de la même façon à tout type de transmission, par voie hertzienne ou par câble.

Tout signal numérique, quel qu'en soit l'origine, peut être codé et décodé selon l'invention. Il peut par exemple s'agir d'un signal d'images, d'un signal sonore, d'un signal de données, ou d'un multiplex de plusieurs signaux distincts.

De façon connue, le codage de tels signaux est en général réalisé à l'aide d'un ou plusieurs codeurs convolutifs. Dans le décodeur, les données d'origine sont le plus souvent reconstruites à l'aide d'un algorithme à maximum de vraisemblance, et par exemple l'algorithme de Viterbi, dont les décisions peuvent éventuellement être pondérées.

Les codes convolutifs sont des codes associant à chaque donnée source à coder au moins une donnée codée, obtenue par sommation modulo 2 de cette donnée source avec au moins une des données source précédentes. Ainsi, chaque symbole codé est une combinaison linéaire de la donnée source à coder et des données source précédentes prises en compte. L'algorithme de Viterbi, en prenant en compte une séquence de symboles codés reçus, fournit une estimation de chaque donnée codée à l'émission, en déterminant la séquence source correspondant le plus probablement à la séquence reçue.

Il est également connu de mettre en série plusieurs codeurs, qu'ils soient convolutifs ou non. Dans ce cas, les données codées par un premier codeur alimentent un second codeur, qui "surcode" ces données. Le décodage se fait évidemment symétriquement, en commençant par le second code.

Ce principe, appelé concaténation de codes, présente deux types d'inconvénients. Tout d'abord, le rendement global des codeurs mettant en oeuvre des codes contaténés est faible. Par exemple, dans le cas de deux codeurs en série ayant chacun un rendement 1/2, le rendement global sera de 1/4. Si l'on utilise plus de deux codeurs, ce rendement devient rapidement très faible.

Par ailleurs, la réalisation technique de ces codeurs est relativement complexe, notamment en ce qui concerne les horloges associées à chaque code, qui doivent être indépendantes.

En ce qui concerne les décodeurs, on a déjà indiqué que l'on mettait généralement en oeuvre des algorithmes à maximum de vraisemblance, tels que l'algorithme de Viterbi. Ces algorithmes prennent des décisions en tenant compte d'un nombre important de symboles reçus. Clairement, la décision est d'autant plus fiable que le nombre de symboles pris en compte est élevé. En revanche, plus ce nombre est élevé, plus le décodeur est complexe. La place mémoire nécessaire devient rapidement très importante, de même que les temps de calcul correspondants.

Les circuits intégrés mettant en oeuvre de tels algorithmes reposent donc le plus souvent sur un compromis entre le coût et les performances. Ces choix industriels ne permettent pas de construire des décodeurs correspondant de façon optimum à une application donnée. Il n'est par exemple pas possible de réaliser des décodeurs à faible prix de revient, pour des applications où la qualité de réception n'est pas cruciale, les circuits intégrés ayant un coût trop élevé. Inversement, ces circuits intégrés ne sont pas non plus adaptés à la réalisation de récepteurs à très haute qualité de décodage, pour lesquels le prix de revient n'a que peu d'importance.

L'invention a notamment pour objectif de pallier ces différents inconvénients et limites de l'état de la technique.

Plus précisément, un objectif de l'invention est de fournir un procédé de codage et un procédé de décodage de données numériques à très bon pouvoir de correction, en comparaison avec les procédés connus utilisés actuellement dans les systèmes de communications numériques.

L'invention a notamment pour objectif de fournir de tels procédés, particulièrement efficaces, toujours par rapport aux procédés connus, pour la transmission dans des canaux très bruités.

Un objectif particulier de l'invention est de fournir de tels procédés autorisant un décodage très fiable des données reçues, et par exemple de données transmises par satellites, ou issues de sondes ou de vaisseaux spatiaux.

L'invention a encore pour objectif de fournir de tels procédés, permettant de coder et de décoder des données à des débits très élevés.

L'invention a également pour objectif de fournir de tels procédés, permettant une réalisation des codeurs et des décodeurs relativement aisée, en regard de leurs performances.

Notamment, l'invention a pour objectif de fournir un procédé de codage mettant en oeuvre plusieurs codes convolutifs, mais ne nécessitant, tant au codeur qu'au décodeur, qu'une seule horloge.

Un autre objectif de l'invention est de fournir un tel procédé de codage, ayant un très bon rendement global de codage.

L'invention a encore pour objectif de fournir des procédés de codage et de décodage, permettant la réalisation de décodeurs très performants, mais malgré tout aisément réalisables industriellement à des coûts acceptables.

Ainsi, un objectif particulier de l'invention est de fournir de tels procédés, permettant l'implantation du procédé de décodage sur une surface de silicium suffisamment restreinte pour que son industrialisation soit possible, et par exemple sur une surface inférieure à 50 mm$^2$.

L'invention a également pour objectif de fournir de tels procédés de codage et de décodage permettant la réalisation de nombreux types de décodeurs, à performances et prix de revient variables en fonction des besoins auxquels ils répondent, et mettant en oeuvre un ou plusieurs circuits intégrés d'un type unique.

En d'autres termes, un objectif essentiel de l'invention est de fournir de tels procédés permettant d'une part une industrialisation rentable, basée sur le développement d'un circuit intégré unique et relativement simple, et d'autre part la réalisation de décodeurs utilisables pour une très grande diversité d'applications.

Ces objectifs, ainsi que d'autres qui apparaîtront par la suite, sont atteints selon l'invention à l'aide d'un procédé de codage correcteur d'erreurs de données numériques source, mettant en oeuvre en parallèle au moins deux étapes indépendantes de codage convolutif systématique, chacune desdites étapes de codage prenant en compte l'ensemble desdites données source, le procédé comprenant au moins une étape d'entrelacement temporel desdites données source, modifiant l'ordre de prise en compte desdites données source entre lesdites étapes de codage.

Ce procédé, appelé par la suite codage à "concaténation parallèle", par opposition à la technique classique de "concaténation série" décrite en préambule, permet de disposer, lors du décodage de symboles issus de deux codeurs distincts.

Les codages redondants utilisés sont de type systématique. Chaque donnée source est donc aussi un symbole de codage convolutif, et ce symbole est partagé par les deux codes.

Le partage de la redondance de codage en plusieurs redondances parallèles permet ainsi d'augmenter artificiellement le rendement global du code. Par exemple, un code à "concaténation parallèle" de rendement 1/3 peut en réalité contenir deux codes de rendement 1/2. S'il s'était agi de concaténer, d'un manière classique, c'est-à-dire par une "concaténation série", deux codes de rendement 1/2, le rendement global aurait été de 1/4.

Un autre avantage des codes à "concaténation parallèle", vis-à-vis des codes "à concaténation série", est la simplicité des circuits de codage et de décodage, relativement aux horloges.

Dans un mode de réalisation préférentiel, le procédé de codage comprend une étape d'élimination systématique, à des instants de transmission prédéterminés, d'au moins une donnée codée produite par au moins une desdites étapes de codage.

L'étape d'élimination peut par exemple consister en une commutation périodique entre lesdites étapes de codage, assurant, à chaque instant de transmission, la sélection d'un unique symbole codé parmi l'ensemble des symboles codés par chacune desdites étapes de codage.

De cette façon, un seul symbole codé est transmis à chaque instant de transmission : il n'y a pas d'augmentation du débit global de données. En revanche, le procédé de codage de l'invention assure la transmission systématique de la donnée source à chaque instant de transmission.

Dans ce mode de réalisation, on utilise des codes dits "pseudo-systématiques", tels que ceux décrits dans la demande de brevet française FR 91 05278 intitulée "procédé de codage convolutif correcteur d'erreurs pseudo-systématique, procédé de décodage et dispositifs correspondants", et déposée le 23 avril 1991 aux noms des mêmes déposants. Ces codes permettent d'obtenir de très bonnes qualités de décodage, en particulier en présence d'un bruit de transmission élevé. Ils s'avèrent par ailleurs très intéressants par leur caractéristique systématique pour la mise en oeuvre du procédé de décodage décrit plus loin.

De façon avantageuse, chacune desdites étapes d'entrelacement temporel est suivie d'une étape de retard, ladite étape d'entrelacement temporel prenant en compte les données source dans l'ordre dans lequel lesdites données source alimentent une première étape de codage, et les restituant dans un ordre différent pour alimenter une seconde étape de codage, ladite étape de retard affectant chacune desdites données source issues de ladite étape d'entrelacement temporel d'un retard égal à la latence de décodage de données codées par ladite première étape de codage.

Ces retards s'avèrent utiles pour la mise en oeuvre d'un mode de réalisation du procédé de décodage de l'invention, ainsi qu'on le verra par la suite.

Avantageusement, ladite étape d'entrelacement temporel met en oeuvre au moins une matrice d'entrelacement dans laquelle lesdites données source sont inscrites par lignes (respectivement colonnes) successives et lues par colonnes (respectivement lignes) successives.

Cette étape d'entrelacement permet que toutes les données source soient prises en compte et codées, mais suivant des séquences différentes pour les deux codes. L'entrelacement peut donc être fait de façon classique, à l'aide d'une matrice d'entrelacement. Toutefois, l'invention propose plusieurs adaptations possibles de cette technique, ayant pour but d'améliorer l'efficacité de l'entrelacement.

Ainsi, de façon préférentielle, à l'écriture, l'incrément entre deux lignes (respectivement colonnes) et/ou, à la lecture, l'incrément entre deux colonnes (respectivement lignes) sont strictement supérieurs à 1.

Par nécessité, ces incréments sont bien sûr également premiers avec le nombre de colonnes ou de lignes de cette matrice.

Avantageusement, à l'écriture (respectivement lecture), ledit incrément entre deux lignes (respectivement colonnes) est fonction de l'emplacement de la colonne (respectivement ligne) en cours d'écriture (respectivement lecture).

Cette technique a pour effet favorable, lors du décodage, de "casser" les paquets d'erreurs à disposition rectangulaire, vis à vis desquels le procédé de décodage est plus vulnérable. Cette technique d'entrelacement sera dite par la suite "à dispersion".

L'invention s'applique en effet conjointement avec un procédé de décodage de données numériques reçues sous forme codée et correspondant à des données source, comprenant une procédure de décodage itérative comprenant :

- une étape de décodage d'une donnée intermédiaire représentative d'une donnée reçue, produisant une donnée decodée, et
- une étape d'estimation de ladite donnée reçue, à l'aide de ladite donnée décodée, produisant une donnée estimée,

ladite donnée intermediaire étant obtenue, pour la première itération, par une combinaison de ladite donnée reçue avec une valeur prédéterminée, et pour les itérations suivantes, par une combinaison de ladite donnée reçue avec au moins une desdites données estimées lors des itérations précédentes.

Ce procédé permet de réaliser des décodeurs constitués d'une cascade de modules identiques, chaque module correspondant à une itération. Il est clair que l'efficacité du décodage est directement fonction du nombre d'itérations pratiquées, et donc du nombre de modules mis en oeuvre. Il est ainsi possible de définir plusieurs niveaux de qualités de récepteurs, simplement en faisant varier le nombre de modules.

Chaque module a donc pour tâche de calculer, outre la donnée décodée, une nouvelle estimation de la donnée émise. Cette grandeur est exploitée dès le module suivant.

Avantageusement, ladite étape d'estimation affecte ladite donnée estimée d'un bruit additif décorrélé du bruit affecté à ladite donnée reçue.

Ainsi, la donnée prise en compte lors de l'itération suivante, combinaison de la donnée reçue et de la donnée estimée, est affectée d'un bruit global moins perturbateur qu'à l'itération précédente.

Dans un mode de réalisation préférentiel de l'invention, ladite valeur prédéterminée est neutre, ou nulle, et lesdites combinaisons sont, pour les itérations autre que la première, des sommations de ladite donnée reçue et de la dernière donnée estimée.

Dans le cas d'un décodage de données codées selon un procédé assurant la transmission conjointe des données source et de données de redondance codées, par exemple à l'aide des codes "pseudo-systématiques" déjà cités, il est avantageux que ladite étape de décodage prenne en compte l'ensemble des données reçues, données source et données codées, mais que ladite étape d'estimation soit appliquée uniquement à l'estimation desdites données source.

Selon un mode de realisation particulier de l'invention, du type assurant le décodage de données codées selon un procédé de codage mettant un oeuvre en parallèle deux étapes de codage redondant, la première étape de codage effectuant un premier codage redondant sur l'ensemble des données source prises dans leur ordre naturel, et la seconde étape de codage effectuant un second codage redondant sur l'ensemble des données source prises dans un ordre modifié par une étape d'entrelacement temporel, le procédé de décodage comprend les étapes consécutives suivantes :

- premier décodage selon ledit premier codage redondant, en fonction d'au moins une desdites données intermédiaires et d'au moins une donnée codée produite par ladite première étape de codage, produisant une première donnée décodée,
- entrelacement temporel identique à ladite étape d'entrelacement du procédé de codage desdites premières données décodées,
- second décodage selon ledit second codage redondant, en fonction d'au moins une desdites premières données décodées et désentrelacées et d'au moins une donnée codée produite par ladite seconde étape de codage, produisant une seconde donnée décodée,
- estimation de la donnée source reçue, en fonction de l'une au moins desdites première et seconde données décodées, produisant une donnée estimée,
- désentrelacement symétrique à ladite étape d'entrelacement desdites données estimées.

Avantageusement, ladite étape d'estimation consiste à déterminer la grandeur $(d_2 \times (X_1)-(X_2))/(d_2 - 1)$, où :

- $d_2$ est la distance libre dudit second codage redondant ;
- $X_1$ et $X_2$ sont les données décodées par lesdites première et seconde étapes de décodage ;

Cette fonction ôte au résultat de la donnée décodée délivrée par la seconde étape de décodage la contribution liée à la donnée source. Ainsi, les bruits additifs de la donnée source et de la donnée estimée sont pratiquement complètement décorrélés.

De façon préférentielle, ladite étape d'estimation est suivie, avant ladite étape de désentrelacement, d'une étape de compression logarithmique.

Cette compression logarithmique a pour but de mettre l'accent, en terme de précision d'échantillonnage, sur les valeurs critiques, c'est-à-dire sur les valeurs proches de zéro, lorsque les valeurs sont codées entre -n et +n.

Dans un mode de réalisation avantageux de l'invention, ladite première étape de décodage est suivie d'une étape de multiplication de ladite première donnée décodée par un coefficient β strictement supérieur à 1.

Ce coefficient β a pour rôle de privilégier, pour le deuxième décodage, les valeurs issues du premier décodeur, relativement aux valeurs codées reçues, affectées d'un bruit plus important car directement fournies par le canal de transmission.

Préférentiellement, ledit coefficient β est variable en fonction du rapport signal à bruit du canal de transmission.

De façon avantageuse, la ou lesdites étapes de décodage mettent en oeuvre des algorithmes de décodage à maximum de vraisemblance, du type de l'algorithme de Viterbi, à décisions pondérées.

On peut notamment faire appel au procédé de décodage décrit dans la demande conjointe intitulée "procédé de décodage d'un code convolutif à maximum de vraisemblance et pondérations des décisions, et décodeur correspondant", déposée aux noms des mêmes déposants.

Avantageusement, le procédé de décodage comprend également une étape de démultiplexage dirigeant les données codées reçues vers lesdites étapes de décodage adéquates et transmettant des valeurs nulles aux étapes de décodage pour lesquelles aucune donnée codée n'a été transmise.

Cette étape est utile lorsque des données codées sont sélectivement non-émises, à certains instants de transmission.

L'invention concerne également un module de décodage, réalisant une itération de la procédure de décodage décrite ci-dessus. Un tel module comprend au moins deux entrées, correspondant à au moins une donnée reçue et à au moins une donnée estimée, et au moins deux sorties, correspondant à au moins une donnée décodée et au moins une donnée estimée. Il est susceptible d'être cascadé avec au moins un autre module identique.

Un module peut notamment être réalisé sous forme de circuit intégré. Un tel circuit occupe suffisamment peu de surface silicium pour permettre une industrialisation aisée, fiable et peu coûteuse.

La modularité permet de prévoir, à partir d'un unique circuit intégré, tout type d'application. Dans les cas ne nécessitant qu'une faible protection, ou lorsque le canal est peu bruité, un seul module peut suffire. En revanche, dans des cas particuliers où la fiabilité est essentielle et/ou le bruit de transmission est important, par exemple dans le cas de données transmises par une sonde intersidérale, dix modules ou plus pourront être cascadés.

L'invention concerne également les décodeurs mettant en oeuvre un ou plusieurs de ces modules.

D'autres caractéristiques et avantages de l'invention apparaîtront à la lecture de la description suivante d'un mode de réalisation préférentiel de l'invention donné à titre illustratif et non limitatif, et des dessins annexés, dans lesquels :

- la figure 1 est un schéma synoptique illustrant le principe de base du procédé de codage de l'invention, dit "à concaténation parallèle" ;
- la figure 2 présente un mode de réalisation particulier d'un codeur selon le procédé illustré en figure 1, assurant une redondance de 100 % ;
- la figure 3 est un schéma synoptique du principe de base d'un décodeur modulaire selon l'invention, à quatre modules ;
- la figure 4 est un schéma synoptique détaillé d'un mode de réalisation préférentiel d'un module de la figure 3, dans le cas où les données sont codées à l'aide du codeur de la figure 2 ;
- les figures 5 et 6 présentent les résultats obtenus à l'aide d'un décodeur utilisant les modules de la figure 4, en fonction du nombre de modules cascadés, dans le cas d'un décodeur idéal (figure 5) et d'un décodeur implantable sur circuit intégré (figure 6) ;
- la figure 7 présente un exemple de module de codage "pseudo-systématique" ayant une longueur de contrainte $\upsilon = 2$ et un rendement R = 1/2 pouvant être utilisé dans le codeur de la figure 1.

La présente invention repose sur deux concepts nouveaux, à savoir un procédé de codage mettant en oeuvre simultanément plusieurs codages, en parallèle, et un procédé de décodage itératif.

Prises en combinaison, ces deux caractéristiques présentent une très forte synergie, permettant d'obtenir au décodage un taux d'erreur particulièrement faible, et notamment très inférieur à ceux obtenus avec les décodeurs connus de complexité équivalente, en particulier en présence d'un bruit de transmission élevé.

Toutefois, il est clair que ces caractéristiques peuvent être mises en oeuvre indépendamment sans sortir du cadre l'invention. On verra d'ailleurs plus loin qu'il est possible de réaliser, selon le mode de réalisation décrit, des décodeurs à un seul module, ce qui correspond à un décodage non-itératif.

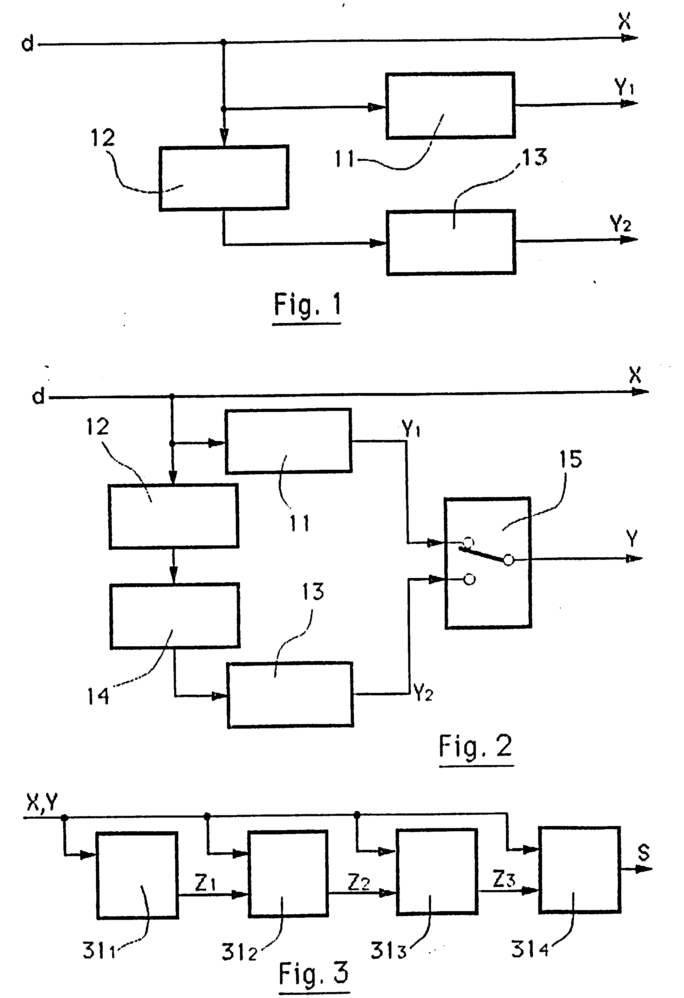

La figure 1 présente un schéma synoptique d'un codeur mettant en oeuvre le procédé de l'invention, dans le cas où deux codes distincts sont utilisés en parallèle.

Chaque donnée source d à coder est dirigée d'une part vers un premier module 11 de codage, et d'autre part vers un module 12 d'entrelacement temporel, qui alimente lui-même un second module 13 de codage.

Selon ce procédé, il apparaît donc qu'il est associé à chaque donnée source d au moins deux données codées $Y_1$ et $Y_2$ issues de codeurs 11 et 13 distincts. Il est clair que le nombre de codeurs, ici limité à deux, peut aisément être étendu selon le même principe.

Les modules 11 et 13 peuvent être de tout type systématique connu. Il s'agit avantageusement de codeurs convolutifs prenant en compte au moins une des données source précédentes pour le codage de la donnée source d. Les codes mis en oeuvre dans ces modules 11 et 13 peuvent être identiques ou, préférentiellement, différents.

Une caractéristique essentielle de l'invention est que les données codées $Y_1$ et $Y_2$ tiennent en compte des mêmes données source d, mais considérées suivant des séquences différentes, grâce à la technique de l'entrelacement. Cet entrelacement peut être obtenu, de façon classique, à l'aide d'une matrice d'entrelacement, dans laquelle les données source sont introduites lignes par lignes, et restituées colonnes par colonnes. Ainsi qu'on le verra plus loin, l'invention propose toutefois des améliorations nouvelles de ce procédé d'entrelacement, destinées notamment à bien séparer les erreurs, au décodage.

Par ailleurs, toute autre technique permettant de modifier l'ordre des données source peut être utilisée dans ce module 12 d'entrelacement temporel.

Dans le mode de réalisation représenté en figure 1, une donnée X, égale à la donnée source d, est systématiquement transmise. Il s'agit d'une caractéristique nécessaire pour la réalisation des modules de décodage tels que décrits plus loin.

Dans ce cas, les modules 11 et 13 de codage utilisent préférentiellement des codes tels que ceux décrits dans la demande de brevet FR 91 05278 déjà citée. Ces codes, dits "pseudo-systématiques", sont caractérisés par le fait que la donnée source est systématiquement transmise, conjointement à au moins une donnée codée, ou symbole de redondance.

Ces symboles de redondance sont construits de façon que la distance libre du code soit maximale. Ils ne tiennent pas compte, ainsi que cela est fait usuellement dans les codes convolutifs, d'une série des données source précédentes, mais d'une série de données auxiliaires, obtenues par combinaison mathématique de la donnée source considérée avec l'une au moins des données auxiliaires précédentes.

Ces codes nouveaux permettent d'obtenir de très bonnes performances, en terme de taux d'erreurs.

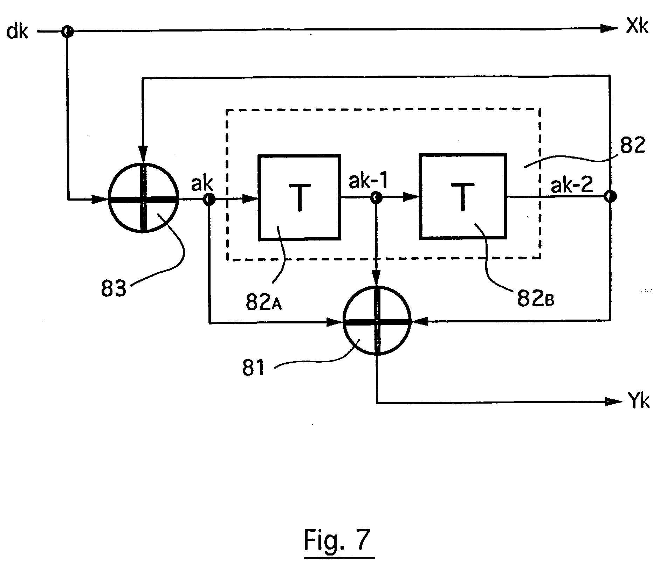

Un exemple de codeur (ayant une longueur de contrainte v = 2 et un rendement R = 1/2) mettant en oeuvre cette technique est illustré en figure 7.

Ce codeur associe à chaque donnée source $d_k$ deux valeurs codées $X_k$ et $Y_k$.

La donnée $X_k$ est systématiquement prise égale à la valeur source $d_k$.

La donnée $Y_k$ est calculée, de façon classique, à l'aide d'une combinaison 81 d'au moins deux éléments binaires contenus dans un registre à décalage 82. En revanche, ce registre 82 ne contient pas, dans ces cellules $82_A$ et $82_B$, les valeurs source précédentes $d_{k-1}$, $d_{k-2}$, mais des valeurs intermédiaires distinctes $a_{k-1}$, $a_{k-2}$.

La caractéristique essentielle de l'invention est en effet de déterminer la valeur codée de $Y_k$ à partie de valeurs particulières $a_k$ obtenues par une combinaison mathématique, et par exemple un OU exclusif 83, de la donnée source $d_k$ avec l'une au moins des valeurs intermédiaires précédentes $a_{k-2}$ (au contraire des procédés de codage convolutif connus qui prennent en compte directement la série des valeurs source précédentes.

Cela revient, en quelque sorte, à effectuer une contre-réaction sur les valeurs sources $d_k$. Il apparaît que cette contre-réaction permet d'obtenir des performances supérieures à celles des codeurs classiques, tout en ne nécessitant que l'ajout d'un OU exclusif 83 à ces codeurs.

Il semble que ce gain puisse notamment être attribué au fait que les emplacements des erreurs de transmission dans une séquence de données reçues ne sont que rarement complètement décorrélées. L'application d'une combinaison par OU exclusif sur ces données peut alors entraîner l'annulation de certaines de ces erreurs.

De nombreuses simulations avec des codes de longueurs de contraintes et/ou de rendements différents ont permis de constater que dans tous les cas de figures, ce procédé de codage "pseudo-systématique" présente des performances supérieures aux codeurs convolutifs classiques équivalents (en terme de rendement et de longueur de contrainte) notamment lorsque le signal reçu est très bruité ($E_b/N_o$ inférieur ou égal à 3 dB).

Le principe du codage à "concaténation parallèle" selon l'invention présente notamment deux avantages, par rapport au codage classique à concaténation série, ainsi qu'on l'a déjà mentionné : d'une part le rendement global du code est meilleur, et, d'autre part, les circuits de codage et de décodage sont plus simples, en ce qui concerne leurs horloges. En effet, dans le cas de la "concaténation parallèle", tous les circuits fonctionnent à une seule et même horloge : celle du débit des données.

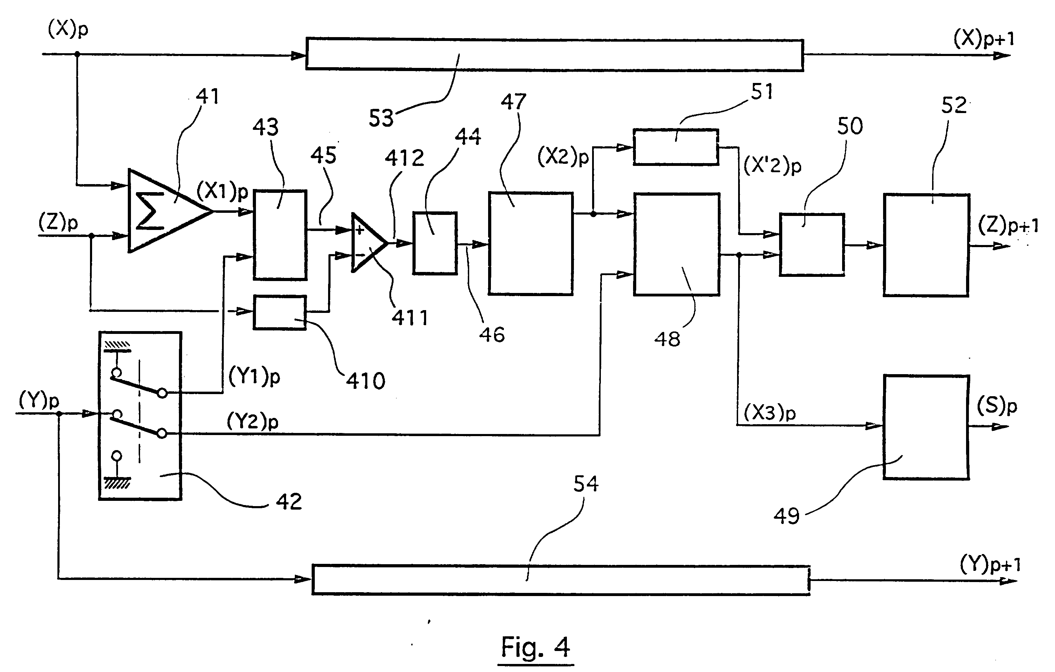

La figure 2 illustre un mode de réalisation particulier d'un tel codeur, plus précisément destiné au codage de données décodables à l'aide des modules décrits plus loin, en relation avec la figure 4.

On considère, à titre d'exemple, un codeur de rendement global R supérieur ou égal à 1/3 (une valeur typique de R est 1/2) mettant en oeuvre deux codes de rendements élémentaires respectifs $R_1$ et $R_2 = (RR_1)/(RR_1 + R_1 - R)$, $R_1$ et $R_2$ étant tous deux supérieurs à 1/2.

Ce codeur émet, à chaque instant de transmission, deux symboles numériques, par exemple binaires, X et Y. Le symbole X est pris systématiquement égal à la donnée source d, et le symbole Y est un symbole de redondance.

Ce symbole Y est égal soit à la valeur $Y_1$ issue du premier module 11 de codage, soit à la valeur $Y_2$ issue du second module 13 de codage. Un module 15 de sélection effectue une commutation périodique entre les sorties $Y_1$ et $Y_2$. La périodicité de la commutation est fixée par les deux rendements $R_1$ et $R_2$, de telle sorte que les symboles X et Y contiennent effectivement deux codes de rendement $R_1$ et $R_2$.

A titre d'exemple, pour des rendements de code $R_1 = 3/5$ et $R_2 = 3/4$, les séquences de données transmises peuvent être :

| $X_t$ | $X_{t+1}$ | $X_{t+2}$ | $X_{t+3}$ | $X_{t+4}$ | $X_{t+5}, \dots$ |
|---|---|---|---|---|---|
| $Y_{1,t}$ | $Y_{1,t+1}$ | $Y_{2,t+2}$ | $Y_{1,t+3}$ | $Y_{1,t+4}$ | $Y_{2,t+5}, \dots$ |

Le fonctionnement de ce module 15 de sélection peut bien sûr être généralisé. Ainsi, dans le cas où il y a plus de deux modules de codage, la sélection peut se faire de façon à assurer la transmission d'un nombre m de données codées, sélectionnées parmi les n données codées produites. Par ailleurs, ce module 15 de sélection peut également assurer un poinçonnage des données codées, la (ou les) donnée Y n'étant pas transmise à des instants de transmission prédéterminés.

Les données source d sont appliquées au premier module de codage 11 et au module 12 d'entrelacement. Ce module 12 assure un entrelacement matriciel. Les données sont écrites, par lignes successives, dans une mémoire de taille $n_E x n_E$, et restituées par colonnes successives. Cette technique est par exemple décrite dans l'article "Optimal interleaving scheme for convolutional coding" (Méthode d'entrelacement optimal pour le codage convolutif), de Dunscombe E. et Piper F.C., paru dans l'"Electronic Letters", Vol.25, n°22, Octobre 1989.

Ainsi que le montre cet article, l'efficacité de l'entrelacement, pour de petites valeurs de $n_E$ (quelques dizaines), est améliorée si la succession de lignes et de colonnes s'effectue selon un incrément supérieur à 1 et, par nécessité, premier avec $n_E$.

L'invention propose une nouvelle amélioration à cette technique d'entrelacement. Il apparaît en effet avantageux que l'incrément de saut de ligne, toujours premier avec $n_E$, soit fonction de la place de la colonne considérée. Cela permet de casser les paquets d'erreurs à disposition rectangulaire.

D'autres techniques d'entrelacement peuvent bien sûr être utilisées, et notamment l'habituel procédé à incréments d'écriture et de lecture égaux à 1, sans sortir du cadre de l'invention. Il est clair par ailleurs que les rôles des lignes et des colonnes peuvent être inversés.

Les données issues du module 12 d'entrelacement sont ensuite retardées d'une durée fixée, de façon à compenser la latence $L_1$ du module de décodage correspondant au premier code 11. Pour cela, des moyens 14 de retard, tel qu'un registre à décalage de longueur $L_1$, tenant lieu de ligne à retard, sont disposés en sortie du module 12 d'entrelacement.

On présente maintenant le procédé de décodage selon l'invention, en liaison avec la figure 3.

Ce procédé de décodage a comme caractéristique essentielle d'être itératif. A chaque itération, le décodage d'au moins une donnée intermédiaire est effectué. A l'aide notamment de la donnée décodée, on détermine ensuite une estimation de la donnée à décoder. Lors de l'itération suivante, un décodage identique est effectué, sur une donnée intermédiaire obtenue par combinaison de la donnée reçue avec la donnée estimée. Si le procédé de codage et le procédé d'estimation sont bien choisis, il apparaît, ainsi qu'on le verra par la suite, que la qualité du décodage est fonction du nombre d'itérations effectuées.

L'avantage essentiel de ce procédé itératif est qu'il permet la réalisation de décodeurs modulaires. On peut en effet définir des modules $31_1$ à $31_4$ de décodage, tel que cela est illustré en figure 3. Chaque module effectue une itération du procédé de décodage. En cascadant n modules, on réalise donc n itérations du procédé.

Le module $31_i$ a au moins deux entrées : la donnée X reçue, à décoder, et une donnée $Z_p$ représentative de cette donnée X reçue, estimée par le module précédent $31_{p-1}$, et deux sorties : la donnée $Z_p$ estimée, et la valeur décodée S, prise en compte uniquement en sortie du dernier module. Pour le premier module $31_1$, la donnée $Z_1$ est fixée à une valeur prédéterminée nulle. Avantageusement, la donnée $Z_p$ est déterminée de façon à être représentative du symbole émis X, tout en étant affectée d'un bruit additif décorrélé de celui affecté à la donnée reçue X. Ainsi, au fur et à mesure des itérations, l'influence du bruit est de plus en plus faible, et le taux d'erreur est donc de plus en plus réduit.

Dans d'autres modes de réalisation chaque module peut prendre en compte plusieurs données $Z_p$ estimées lors des étapes précédentes, voire l'ensemble de ces données. La combinaison avec la donnée X recue peut être une simple sommation, ou une sommation pondérée. Il est par exemple envisageable de donner un poids variable aux différentes valeurs $Z_p$ estimées. Il est également possible que ces poids varient en fonction de certains critères, tels que le rapport signal à bruit.

La structure modulaire de l'invention présente notamment deux avantages. Tout d'abord, cela permet de définir plusieurs qualités de décodeurs, à partir d'une même base, simplement en faisant varier le nombre de modules. Cela rend également possible d'augmenter aisément l'efficacité d'un décodeur existant, en ajoutant un ou plusieurs modules, si le besoin s'en fait sentir.

Les différents modules travaillent selon la technique dite "en pipe-line". Chaque module fonctionne en permanence, sur des données différentes. L'ajout d'un module ne perturbe pas le fonctionnement de ses précédécesseurs. Il ne fait que rallonger légèrement le temps global de décodage, de la durée nécessaire à ses propres opérations.

Par ailleurs, cette structure ne nécessite que la conception et l'industrialisation d'un seul module de décodage, par exemple sous forme d'un circuit intégré relativement simple et ne nécessitant pas une surface de silicium trop importante. Son coût n'est donc pas prohibitif, d'autant plus qu'il est susceptible d'être utilisé pour une très large palette d'applications. Selon les besoins, c'est le nombre des modules qui sera variable, et non plus la structure des modules.

Il est à noter que la conception itérative du procédé de l'invention n'empêche aucunement la réalisation de décodeurs plus conventionnels, n'utilisant qu'un unique module. En effet, chaque module possède une entrée donnée reçue et une sortie donnée S décodée.

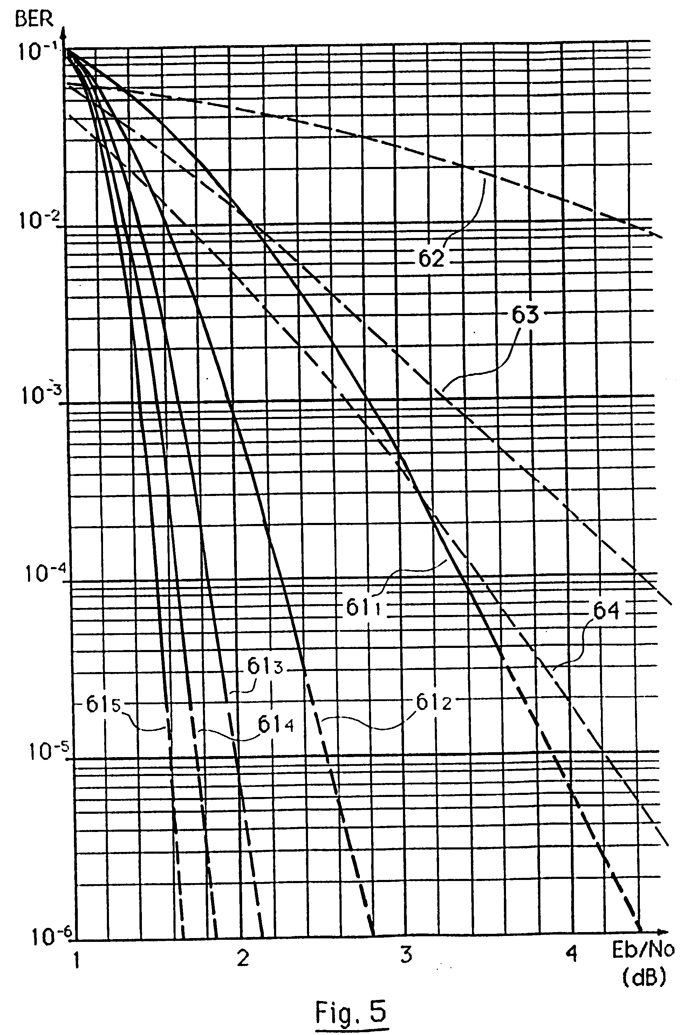

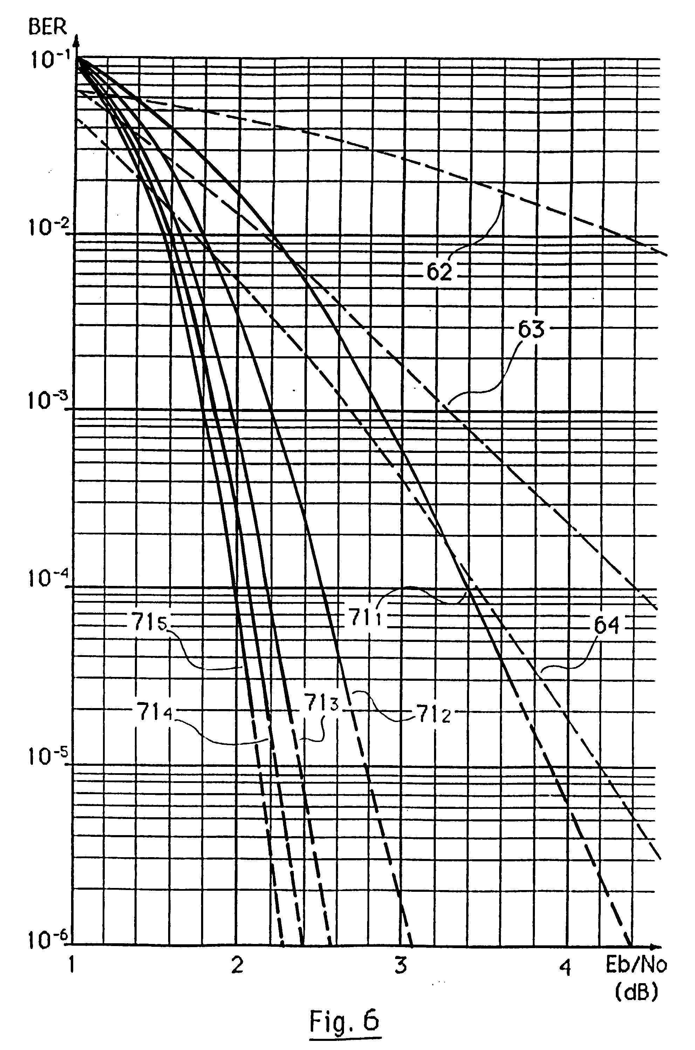

La figure 4 présente un mode de réalisation particulier d'un module selon l'invention, dont les performances sont très intéressantes, ainsi que le font apparaître les courbes des figures 5 et 6, commentées plus loin.

Ce module est destiné au décodage de données codées et transmises à l'aide du codeur de la figure 2.

Un tel module de rang p possède donc :

- 3 entrées : $(X)_p$, $(Y)_p$ et $(Z)_p$,
- 4 sorties : $(X)_{p+1}$ $(Y)_{p+1}$, $(Z)_{p+1}$ et $(S)_p$.

Les grandeurs (X), (Y) et (Z) sont idéalement des variables réelles, et en pratique des échantillons codés sur n bits (typiquement n=4). La grandeur (S), qui représente la sortie du module, est binaire. La décision du décodeur complet est donnée par la sortie (S) du dernier module. Pour ce qui concerne le premier module, les grandeurs d'entrée $(X)_1$ et $(Y)_1$ sont fournies par les symboles correspondants du codeur, après transmission et démodulation. Son entrée $(Z)_1$ est mise à une valeur neutre (poids nul).

Dans ce module, les données en entrée $(X)_p$ et $(Z)_p$ sont additionnées par un sommateur 41 pour fournir la donnée intermédiaire $(X_1)_p$, qui va être utilisée pour le décodage en lieu et place de la donnée reçue $(X)_p$. Ainsi qu'on l'a déjà souligné, les données $(X)_p$ et $(Z)_p$ peuvent éventuellement être pondérées.

La donnée $(Y)_p$ est transmise à des moyens 42 de démultiplexage et d'insertion, dont le rôle est de séparer la redondance $(Y_1)$ produite par le codeur 11 (figure 2) et la redondance $(Y_2)$ produite par le codeur 13, et d'insérer à la place des valeurs (y) non disponibles des valeurs neutres, de poids nul.

Les données $(X_1)_p$ et $(Y_1)_p$ sont transmises à un premier décodeur 43, réalisant le décodage correspondant au codeur 11. Ce décodeur 43 est construit de telle manière que l'échelle sur son entrée $(X_1)$ soit double de celle de son entrée $(Y_1)$, de façon à tenir compte du fait que $(X_1)$ représente la sommation des deux valeurs (X) et (Z).

La sortie 45 du décodeur 43 est transmise à un soustracteur 411 qui effectue la différence 412 entre cette sortie 45 et l'entrée (Z) considérée à un instant homogène, grâce au registre à décalage 410. (Z) étant une information produite et utilisée par le deuxième décodeur 48 (décrit par la suite) du module précédent, dans le cas d'un décodeur à au moins deux modules de décodage, il est en effet préférable de ne pas la réappliquer lors d'itérations ultérieures.

La différence 412 est ensuite transmise à un multiplieur 44, qui multiplie cette valeur 412 par un facteur $\beta$ supérieur à 1. La multiplication par $\beta$ permet de privilégier, en vue du second décodage, les données issues du premier décodeur 43, relativement aux données $(Y_2)_p$, affectées d'un bruit plus important, puisque directement issues du canal de transmission.

Le facteur $\beta$ peut être fixe. Toutefois, il est avantageusement variable, et dépendant du rapport signal à bruit du canal de transmission. Il est clair par ailleurs que ce multiplieur n'est pas obligatoire pour la mise en oeuvre de l'invention. Il permet cependant d'améliorer sensiblement les performances.

Les données 46 multipliées par $\beta$ sont ensuite entrelacées, à l'aide d'une matrice 47 de taille $n_E$ x $n_E$ similaire à celle utilisée lors du codage. Cette matrice 47 fournit en sortie la valeur $(X_2)_p$ qui est dirigé vers un second décodeur 48, qui prend également en compte les données $(Y_2)_p$ fournit par les moyens 42 de démultiplexage et d'insertion. Ce second décodeur 48 réalise le décodage correspondant au second codeur 13 de la figure 2. Il est construit de telle sorte que l'échelle sur son entrée $(X_2)$ soit $\beta$ fois plus grande que celle de son entrée $(Y_2)$.

Il est à noter que si le codage a lieu en parallèle, le décodage a lieu en série. Ainsi, le second décodeur 48 ne tient pas compte de la donnée reçue $(X)_p$, mais de la donnée décodée, et bien sûr entrelacée, $(X_2)_p$, qui est beaucoup plus fiable. C'est d'ailleurs pour cette raison que cette donnée voit son importance renforcée, par le multiplieur 44.

Avantageusement, les deux décodeurs 43 et 48 mettent en oeuvre un procédé de décodage à maximum de vraisemblance, du type de ceux utilisant l'algorithme de Viterbi, à décisions pondérées.

Dans un mode de réalisation préférentiel, on utilise des décodeurs tels que décrits dans la demande de brevet FR 91 05279, intitulée "procédé de décodage d'un code convolutif à maximum de vraisemblance et pondération des décisions, et décodeur correspondant", déposée le 23.04.91 aux noms des mêmes déposants.

Ces décodeurs mettent notamment en oeuvre deux treillis distincts. La décision est prise, de façon classique, par remontée du chemin optimal dans le premier treillis. La pondération est déterminée ensuite, en continuant à remonter, dans le second treillis, le chemin optimal et son concurrent.

Selon le procédé de cette demande, les valeurs de pondération sont avantageusement soumises à une compression logarithmique. Toutefois, dans le cas du module décrit actuellement, il est apparu préférable que seul le premier décodeur 43 utilise cette loi de compression logarithmique. Elle est en quelque sorte reportée, dans le cas du second décodeur 48, ainsi qu'on le verra plus loin.

Les données $(X_3)_p$ produites par le second décodeur 48 alimentent une matrice 49 de désentrelacement de taille $n_E x n_E$ réalisant la fonction duale de l'entrelacement 47, et fournissant les données $(S)_p$ décodées.

Ces données $(S)_p$ décodées ne sont bien sûr prises en compte qu'en sortie du dernier module, qui présente le taux d'erreurs le plus faible, sauf dans le cas de tests, par exemple pour déterminer le nombre de modules nécessaires pour une application donnée.

Les données $(X_3)_p$ sont par ailleurs dirigées vers le bloc 50 d'estimation de la valeur $(X)_p$ en entrée. Ce bloc 50 tient également compte de la valeur correspondante $(X'_2)_p$, entrée du second décodeur 48, et mémorisé dans un registre à décalage 51, tenant lieu de ligne à retard. Ce registre 51, de longueur $L_2$, $L_2$ étant la latence du second décodeur 48, a pour but de compenser le temps de décodage de ce décodeur 48, de façon que le module 50 considère les données d'entrée $(X'_2)_p$ et de sortie $(X_3)_p$ du second décodeur à des instants homogènes.

Le rôle de ce bloc 50 d'estimation est donc de déterminer une estimation $(Z)_p$ du symbole émis X. Cette estimation est faite de façon que la grandeur $(Z)_p$ soit affectée d'un bruit additif décorrélé de celui affectant le symbole (X). $(Z)_p$ est prise en compte dans le module suivant $(p+1)$. Ainsi, dans ce module $(p+1)$, le premier décodeur traite un code virtuel, de rendement $R_1/(1+R_1)$, $R_1$ étant le rendement du premier codeur 11.

La décorrélation entre les bruits additifs de $(X)_p$ et $(Z)_p$ peut par exemple être assurée par une fonction g, qui ôte au résultat $(X_3)_p$ du second décodeur 48 la contribution liée à $(X)_p$. La fonction g est avantageusement la suivante :

$$g((X_2)_p, (X_3)_p) = (d_2 x(X_3)_p - (X_2)p)/(d_2 - 1)$$

où $d_2$ est la distance libre du second code.

Le bloc 50 réalise ensuite avantageusement une compression logarithmique, précisément celle qui a été supprimée dans le second décodeur 48, des valeurs $g((X_2)_p, (X_3)_p)$. Les valeurs ainsi obtenues sont transmises à une matrice 52 de désentrelacement, identique à la matrice 49, et fournissant la sortie $(Z)_{p+1}$.

Le module de rang p assure par ailleurs la transmission des données reçues (X) et (Y), avec des retards permettant de présenter des sorties à des instants homogènes, pour le module suivant le rang $p+1$. Chaque module comprend donc deux registres à décalage 53 et 54, respectivement pour les données (X) et (Y). Ces registres à décalage tiennent lieu de lignes à retard, et ont une longueur de : $L_1 + L_2 + 2n_E^2$, de façon à compenser :

- la latence $L_1$ du premier décodeur 43 ;
- la latence $n_E^2$ de la matrice 47 d'entrelacement ;
- la latence $L_2$ du second décodeur 48 ;
- la latence $n_E^2$ de la matrice 52 de désentrelacement.

Les figures 5 et 6 présentent les résultats obtenus à l'aide d'un décodeur équipé de tels modules, pour un code de rendement 1/2 du type $3/5(\upsilon=4)//3/4(\upsilon=4)$, c'est-à-dire une concaténation parallèle de deux codes de rendements 3/5 et 3/4, à longueurs de contrainte $\upsilon=4$. L'abscisse des courbes est le rapport signal à bruit $E_b/N_0$ sur le canal de transmission ($E_b$ : énergie reçue par bit utile, $N_0$ : densité spectrale monolatérale de bruit). L'ordonnée est le taux d'erreurs binaires observé : les courbes présentent les résultats de décodage obtenus par simulation d'un canal gaussien, la démodulation étant cohérente.

La figure 5 correspond à un décodeur idéal travaillant sur des variables réelles et avec un entrelacement de grande taille. La figure 6 présente le cas d'un décodeur "intégrable" sur circuit intégré, dont les caractéristiques principales sont les suivantes :

- échantillons codés sur 4 bits,
- longueur de treillis pour chaque décodeur : 58 dont 25 étages de révision pour la pondération,
- $\beta=1.5$,
- entrelacement à dispersion 31x31.

Les courbes $61_1$ à $61_5$ de la figure 5 et $71_1$ à $71_5$ de la figure 6 représentent respectivement les sorties $(S)_p$ d'une chaîne de cinq modules identiques. A titre de comparaison, on a également fait figurer les courbes 62 correspondant à une transmission non codée, et les courbes 63 et 64 correspondant aux courbes de correction des codes standards simples à longueurs de contrainte $\nu=4$ et $\nu=6$ respectivement.

Ces courbes permettent de tirer plusieurs conclusions. On constate tout d'abord qu'en présence d'un fort bruit de transmission, les résultats obtenus sont exceptionnellement meilleurs que ceux obtenus selon les techniques connues. Ainsi, par exemple, pour un taux d'erreur de $10^{-5}$, on constate que le gain est supérieur à 1,5dB, pour un décodeur à deux modules, et supérieur à 2,5dB, pour un décodeur à cinq modules, par rapport à un décodeur classique à longueur de contrainte $\upsilon=6$ (alors que les codeurs utilisés pour la simulation des performances de l'invention ont des longueurs de contrainte $\upsilon=4$).

Il apparaît également que les performances d'un décodeur de l'invention sont meilleures que celles des décodeurs connus, dès lors qu'on vise un taux d'erreurs de l'ordre de $10^{-4}$, même lorsque l'on utilise un seul module (courbes $61_1$ et $71_1$).

Enfin, on peut noter que chaque module rajouté permet d'améliorer la qualité du décodage, en s'approchant de la limite de Shannon, qui est 0 dB pour un code de rendement 1/2. A l'aide de cette série de courbes $61_1$ à $61_5$, il est possible de sélectionner, en fonction d'une application particulière, le nombre de modules nécessaires.

Les pertes de performances, à fort bruit, dans le cas "intégrable" (courbes $71_1$ à $71_5$) relativement au cas idéal (courbes $61_1$ à $61_5$), sont presque entièrement liées à la taille très réduite de la matrice d'entrelacement. On a en effet choisi des matrices de petite taille (31x31) de façon à limiter la surface de silicium utilisée. Avec de telles matrices, la surface de silicium occupée est de l'ordre de 30mm$^2$. L'expérience montre toutefois que des matrices plus grandes, de l'ordre de 100x100 (ce qui correspond à des mémoires RAM de tailles tout à fait classiques), permettent d'améliorer fortement les performances, tout en restant dans des limites tout à fait acceptables du point de vue de l'industrialisation d'un circuit intégré.

## Revendications

1. Procédé de codage correcteur d'erreurs de données numériques source (d), caractérisé en ce qu'il met en oeuvre en parallèle au moins deux étapes (11,13) indépendantes de codage convolutif systématique, chacune desdites étapes (11,13) de codage prenant en compte l'ensemble desdites données source (d),
   et en ce qu'il comprend au moins une étape (12) d'entrelacement temporel desdites données source (d), modifiant l'ordre de prise en compte desdites données source (d) entre lesdites étapes (11,13) de codage.

2. Procédé selon la revendication 1, caractérisé en ce qu'il comprend une étape (15) d'élimination systématique, à des instants de transmission prédéterminés, d'au moins une donnée codée ($Y_1$, $Y_2$) produite par au moins une desdites étapes (11,13) de codage.

3. Procédé selon la revendication 2, caractérisé en ce que ladite étape (15) d'élimination consiste en une commutation périodique entre lesdites étapes (11,13) de codage, assurant, à chaque instant de transmission, la sélection d'une unique donnée codée (Y) parmi l'ensemble des données ($Y_1$, $Y_2$) codées par chacune desdites étapes (11,13) de codage.

4. Procédé selon l'une quelconque des revendications 1 à 3, caractérisé en ce que chacune desdites étapes (12) d'entrelacement temporel est suivie d'une étape (14) de retard,

   ladite étape (12) d'entrelacement temporel prenant en compte les données source (d) dans l'ordre dans lequel lesdites données source (d) alimentent une première étape (11) de codage, et les restituant dans un ordre différent pour alimenter une seconde étape (13) de codage,
   ladite étape (14) de retard affectant chacune desdites données source (d) issues de ladite étape (12) d'entrelacement temporel d'un retard égal à la latence de décodage des données ($Y_1$) codées par ladite première étape (11) de codage.

5. Procédé selon l'une quelconque des revendications 1 à 4, caractérisé en ce que ladite étape (12) d'entrelacement temporel met en oeuvre au moins une matrice d'entrelacement dans laquelle lesdites données source (d) sont inscrites par lignes (respectivement colonnes) successives et lues par colonnes (respectivement lignes) successives.

6. Procédé selon la revendication 5, caractérisé en ce que, à l'écriture, l'incrément entre deux lignes (respectivement colonnes) et/ou, à la lecture, l'incrément entre deux colonnes (respectivement lignes) sont strictement supérieurs à 1.

7. Procédé selon la revendication 6, caractérisé en ce que ledit incrément entre deux lignes (respectivement colonnes) est fonction de l'emplacement de la colonne (respectivement ligne) en cours d'écriture (respectivement de lecture).

8. Procédé de codage et de décodage de données numériques $((X)_p, (Y_1)_p, (Y_2)_p)$ dans lequel le codage est effectué selon le procédé de la revendication 1 et dans lequel le décodage est itératif et comprend les étapes suivantes :

   - détermination d'une donnée intermédiaire $((X_1)_p)$ obtenue par combinaison d'une donnée reçue avec, pour la première itération, une valeur prédéterminée et, pour les itérations suivantes, avec une donnée estimée $((Z)_p)$ lors des itérations précédentes
   - premier décodage (43) selon le premier codage convolutif, en fonction d'au moins une desdites données intermédiaires $((X_1)_p)$ et d'au moins une donnée codée $((Y_1)p)$ produite par ladite première étape (11) de codage, produisant une première donnée décodée (45),
   - entrelacement temporel (47) identique à ladite étape (12) d'entrelacement du procédé de codage desdites premières données décodées (45), produisant des premières données $((X_2)_p)$ décodées et désentrelacées,
   - second décodage (48) selon le second codage convolutif, en fonction d'au moins une desdites premières données $((X_2)_p)$ décodées et désentrelacées et d'au moins une donnée $((Y_2)_p)$ codée produite par ladite seconde étape (13) de codage, produisant une seconde donnée $((X_3)_p)$ décodée,
   - estimation (50) de la donnée source reçue $((X)_p)$, en fonction de l'une au moins desdites première et seconde données décodées $((X_2)_p, (X_3)_p)$, produisant une donnée estimée $((Z)_{p+1})$,
   - désentrelacement (52) symétrique à ladite étape (47) d'entrelacement desdites données estimées $((Z)_{p+1})$.

9. Procédé selon la revendication 8, caractérisé en ce qu'il met en oeuvre une procédure de décodage itérative comprenant :

   - une étape (43,48) de décodage d'une donnée intermédiaire $((X_1)_p)$ représentative d'une donnée reçue $((X)_p)$, produisant une donnée décodée $((X_3)_p)$, et
   - une étape d'estimation (50) de ladite donnée reçue $((X)_p)$, à l'aide de ladite donnée décodée $((X_3)_p)$, produisant une donnée estimée $((Z)_p)$,

   et en ce que ladite donnée intermédiaire $((X_1)_p)$ est obtenue, pour la première itération, par une combinaison (41) de ladite donnée reçue $((X)_p)$ avec une valeur prédéterminée, et pour les itérations suivantes, par une combinaison de ladite donnée reçue $((X)_p)$ avec au moins une desdites données estimées $((Z)_p)$ lors des itérations précédentes.

10. Procédé selon la revendication 9, caractérisé en ce que ladite étape d'estimation affecte à ladite donnée estimée $((Z)_p)$ un bruit additif décorrélé du bruit affecté à ladite donnée reçue $((X)_p)$.

11. Procédé selon l'une quelconque des revendications 9 et 10, caractérisé en ce que ladite valeur prédéterminée est neutre, et en ce que lesdites combinaisons (41) sont, pour les itérations autre que la première, des sommations de ladite donnée reçue $((X)_p)$ et de la dernière donnée estimée $((Z)_p)$.

12. Procédé selon l'une quelconque des revendications 8 à 11, du type appliqué au décodage de données codées selon un procédé assurant la transmission conjointe des données source $((X)_p)$ et de données de redondance codées $((Y_1)_p, (Y_2)_p)$, caractérisé en ce que ladite étape de décodage prend en compte l'ensemble des données reçues, données source $((X)_p)$ et données codées $((Y_1)_p, (Y_2)_p)$, et en ce que ladite étape d'estimation est appliquée uniquement à l'estimation desdites données source $((X)_p)$.

13. Procédé selon l'une quelconque des revendications 8 à 12, caractérisé en ce que ladite étape d'estimation (50) consiste à déterminer la grandeur $(d_2 \times (X_1)-(X_2))/(d_2-1)$, où:

- $d_2$ est la distance libre dudit second codage redondant ;
- $(X_1)$ et $(X_2)$ sont les données décodées par lesdites première (43) et seconde (48) étapes de décodage.

14. Procédé selon l'une quelconque des revendications 8 à 13, caractérisé en ce que ladite étape (50) d'estimation est suivie, avant ladite étape (52) de désentrelacement, d'une étape de compression logarithmique.

15. Procédé selon l'une quelconque des revendications 8 à 14, caractérisé en ce que ladite première étape (43) de décodage est suivie d'une étape (44) de multiplication de ladite première donnée décodée (45) par un coefficient β strictement supérieur à 1.

16. Procédé selon la revendication 15, caractérisé en ce que ledit coefficient β est variable en fonction du rapport signal à bruit du canal de transmission.

17. Procédé selon l'une quelconque des revendications 8 à 16, caractérisé en ce que ladite première étape (43) de décodage est suivie d'une étape (411) de soustraction à ladite première donnée décodée (45) de ladite donnée estimée $((Z)_p)$.

18. Procédé selon l'une quelconque des revendications 8 à 17, caractérisé en ce que la ou lesdites étapes (43,48) de décodage mettent en oeuvre des algorithmes de décodage à maximum de vraisemblance, du type de l'algorithme de Viterbi, à décisions pondérées.

19. Procédé selon l'une quelconque des revendications 8 à 18, caractérisé en ce qu'il comprend une étape (42) de démultiplexage dirigeant les données codées reçues $((Y_1)_p, (Y_2)_p))$ vers lesdites étapes (43,48) de décodage adéquates et transmettant des valeurs nulles aux étapes (43,48) de décodage pour lesquelles aucune donnée codée n'a été transmise.

20. Module de décodage, caractérisé en ce qu'il comprend au moins deux entrées $((X)_p, (Y)_p, (Z)_p)$, correspondant à au moins une donnée reçue $((X)_p,(Y)_p)$ et à au moins une donnée estimée $((Z)_p)$, et au moins deux sorties $((Z)_{p+1}, (S)_p)$, correspondant à au moins une donnée décodée $((S)_p)$ et au moins une donnée estimée $((Z)_{p+1})$, et :

   - des moyens (41) de sommation des entrées correspondant à ladite donnée reçue $((X)_p)$ et à ladite donnée estimée $((Z)_p)$ ;
   - des premiers moyens (43) de décodage de données codées $((X)_p, (Y1)_p)$ selon un premier codage convolutif, prenant en compte les données $((X_1)_p)$ issues desdits moyens (41) de sommation ;
   - des premiers moyens (47) d'entrelacement des données issues desdits premiers moyens (43) de décodage ;
   - des seconds moyens (48) de décodage de données codées $((X_2)_p, (Y_2)_p)$ selon un second codage redondant ;
   - des moyens (50) d'estimation de ladite (ou desdites) donnée(s) reçue(s) $((X)_p)$ ;
   - des moyens (52) de désentrelacement des données $((Z)_p)$ issues desdits moyens (50) d'estimation ;
   - des moyens (49) de désentrelacement des données $((X_3)_p)$ issues desdits seconds moyens (48) de décodage, délivrant les données $((S)_p)$ décodées dans leur ordre d'origine ;
   - des moyens (51,53,54) de retards destinés à compenser les latences des moyens (43,48) de décodage, des moyens (47) d'entrelacement et des moyens (49,52) de désentrelacement de façon que l'ensemble des données $((X)_p, (Z)_p, (S)_p, (Y)_p)$ issues dudit module correspondent à un même instant de réception.

21. Module selon la revendication 20, caractérisé en ce qu'il est susceptible d'être cascadé avec au moins un autre module $(31_{p+1})$ identique.

22. Décodeur de données numériques, caractérisé en ce qu'il comprend au moins un module $(31_p)$ selon l'une quelconque des revendications 20 ou 21.

**Patentansprüche**

1. Verfahren zur fehlerberichtigenden Kodierung digitaler Quelldaten (d),
   dadurch gekennzeichnet, daß es parallel zueinander mindestens zwei unabhängige Schritte (11, 13) systematisch faltender Kodierung anwendet, wobei jede dieser Kodierschritte (11, 13) die Gesamtheit der Quelldaten (d) berücksichtigt und, daß es mindestens einen Schritt (12) zur zeitlichen Verschachtelung dieser Quelldaten (d) umfaßt, der die Reihenfolge der Berücksichtigung dieser Quelldaten zwischen den Schritten (11, 13) ändert.

**2.** Verfahren gemäß Anspruch 1,
dadurch gekennzeichnet, daß es einen Schritt (15) zur systematischen Eliminierung mindestens eines der kodierten Werte ($Y_1$, $Y_2$) zu gegebenen Sendezeitpunkten umfaßt, die sich aus mindestens einem der Kodierschritte (11, 13) ergeben.

**3.** Verfahren gemäß Anspruch 2,
dadurch gekennzeichnet, daß der Eliminierungsschritt (15) aus einer periodischen Kommutation zwischen den Kodierschritten (11, 13) besteht, wobei zu jedem Augenblick der Sendung die Auswahl eines einzigen kodierten Wertes (Y) unter der Menge der Daten ($Y_1$, $Y_2$) durch jeden der Kodierschritte (11, 13) sichergestellt wird.

**4.** Verfahren gemäß einem der Ansprüche 1 bis 3,
dadurch gekennzeichnet, daß auf jedem der Schritte (12) zur zeitlichen Verschachtelung ein Verzögerungsschritt (14) folgt,

wobei der Schritt (12) zur zeitlichen Verschachtelung die Quelldaten (d) in der Reihenfolge, in der diese Quelldaten (d) einen ersten Kodierschritt (11) speisen, berücksichtigt und sie in einer anderen Reihenfolge wiedergibt, um einen zweiten Kodierschritt (13) zu speisen,
wobei der Verzögerungsschritt (14) jede der Quelldaten (d), die sich aus dem zeitlichen Verschachtelungsschritt (12) ergeben, mit einer Verzögerung behaftet, die gleich der Dekodierungslatenz der Daten ($Y_1$) ist, welche durch den ersten Kodierschritt (11) kodiert werden.

**5.** Verfahren gemäß einem der Ansprüche 1 bis 4,
dadurch gekennzeichnet, daß der Schritt (12) zur zeitlichen Verschachtelung mindestens eine Verschachtelungsmatrix anwendet, in der die Quelldaten (d) nach aufeinanderfolgenden Zeilen (bzw. Spalten) eingegeben werden und nach aufeinanderfolgenden Spalten (bzw. Zeilen) gelesen werden.

**6.** Verfahren gemäß Anspruch 5,
dadurch gekennzeichnet, daß beim Eingeben das Inkrement zwischen zwei Zeilen (bzw. Spalten) und/oder beim Lesen das Inkrement zwischen zwei Spalten (bzw. Zeilen) streng größer als 1 ist.

**7.** Verfahren gemäß Anspruch 6,
dadurch gekennzeichnet, daß das Inkrement zwischen zwei Zeilen (bzw. Spalten) eine Funktion der Stellung der Spalte (bzw. Zeile) während der Eingabe (bzw. des Lesens) ist.

**8.** Verfahren für das Kodieren und Dekodieren digitaler Daten (($X)_p$, ($Y_1)_p$, ($Y_2)_p$), bei dem das Kodieren nach dem Verfahren von Anspruch 1 erfolgt und das Dekodieren iterativ ist und die folgenden Schritte umfaßt:

- Festlegung eines Zwischenwertes (($X_1)_p$), der durch Kombination eines empfangenen Wertes mit einem im voraus festgelegten Wert bei der ersten Iteration und mit einem bei den vorhergehenden Iterationen geschätzten Wert (($Z)_p$) bei den folgenden Iterationen;

- eine erste Dekodierung (43) nach der ersten faltenden Kodierung, als Funktion von mindestens einem dieser Zwischenwerte (($X_1)_p$) und mindestens einem bei dem ersten Kodierschritt (11) erzeugten kodierten Wert (($Y_1)_p$), wobei ein erster dekodierter Wert (45) erzeugt wird;

- eine zeitliche Verschachtelung (47), die mit dem Verschachtelungsschritt (12) des Kodierverfahrens der ersten dekodierten Daten (45) identisch ist, welche die ersten dekodierten und entschachtelten Daten (($X_2)_p$) erzeugt;

- eine zweite Dekodierung (48) gemäß der zweiten faltenden Kodierung, als Funktion von mindestens einem der ersten dekodierten und entschachtelten Daten (($X_2)_p$) und von mindestens einem kodierten Wert (($Y_2)_p$), der durch den zweiten Kodierschritt (13) erzeugt wird und einen zweiten dekodierten Wert (($X3)_p$) erzeugt;

- eine Schätzung (50) des empfangenen Quellenwertes (($X)_p$) als Funktion von mindestens einem der ersten und zweiten dekodierten Daten (($X_2)_p$), (($X_3)_p$), wobei der Schätzwert (($Z)_{p+1}$) erzeugt wird;

- die symmetrische Entschachtelung (52) des Verschachtelungsschrittes (47) der Schätzwerte (($Z)_{p+1}$).

**9.** Verfahren gemäß Anspruch 8,

EP 0 511 141 B1

dadurch gekennzeichnet, daß es eine iterative Kodiermethode anwendet, die folgendes umfaßt:

- einen Dekodierschritt (43, 48) eines Zwischenwertes $((X_1)_p)$, der für einen empfangenen Wert $((X)_p)$ repräsentativ ist und einen dekodierten Wert $((X_3)_p)$ erzeugt sowie

- einen Schritt (50) zum Schätzen des empfangenen Wertes $((X)_p)$ mit Hilfe des dekodierten Wertes $((X_3)_p)$, wobei ein geschätzter Wert $((Z)_p)$ erzeugt wird,

und dadurch, daß der Zwischenwert $((X_1)_p)$ bei der ersten Iteration durch Kombination eines empfangenen Wertes mit einem im voraus festgelegten Wert und bei den folgenden Iterationen, mit mindestens einem bei den vorhergehenden Iterationen geschätzten Wert $((Z)_p)$.

10. Verfahren gemäß Anspruch 9,
dadurch gekennzeichnet, daß der Schätzungsschritt dem Schätzwert $((Z)_p)$ ein zusätzliches Rauschen zuordnet, das von demjenigen Rauschen dekorreliert ist, welches dem empfangenen Wert $((X)_p)$ zugeordnet ist.

11. Verfahren gemäß einem der Ansprüche 9 oder 10,
dadurch gekennzeichnet, daß der im voraus festgelegte Wert neutral ist und daß die Kombinationen (41) für alle Iterationen, mit Ausnahme der ersten, Summen des empfangenen Wertes $((X)_p)$ und des ersten geschätzten Wertes $((Z)_p)$ sind.

12. Verfahren gemäß einem der Ansprüche 8 bis 11,
von der Art, die auf die Dekodierung von Daten angewandt wird, welche nach einem Verfahren kodiert wurden, das die gemeinsame Übertragung der Quelldaten $((X)_p)$ und der kodierten Redundanzdaten $((Y_1)_p)$, $((Y_2)_p)$ sicherstellt, dadurch gekennzeichnet, daß der Dekodierschritt die Menge der empfangenen Daten, der Quelldaten $((X)_p)$ und der kodierten Daten $((Y_1)_p)$, $((Y_2)_p)$ berücksichtigt und, daß der Schätzungsschritt nur auf die Schätzung der Quelldaten $((X)_p)$ angewandt wird.

13. Verfahren gemäß einem der Ansprüche 8 bis 12,
dadurch gekennzeichnet, daß der Schätzungsschritt (50) in der Festlegung der Größe $(d_2 \times (X_1)-(X_2))/d_2 -1)$ besteht, wobei:

- $d_2$ der freie Abstand der zweiten redundanten Kodierung ist;
- $(X_1)$ und $(X_2)$ die Daten sind, die vom ersten Dekodierschritt (43) und vom zweiten Dekodierschritt (48) dekodiert wurden.

14. Verfahren gemäß einem der Ansprüche 8 bis 13,
dadurch gekennzeichnet, daß dem Schätzungsschritt (50), vor dem Entschachtelungsschritt (52), ein Schritt zur logarithmischen Kompression folgt.

15. Verfahren gemäß einem der Ansprüche 8 bis 14,
dadurch gekennzeichnet, daß der erste Dekodierschritt (43) von einem Schritt (44) gefolgt wird, bei dem der erste dekodierte Wert (45) mit einem Koeffizienten $\beta$ multipliziert wird, der streng größer als 1 ist.

16. Verfahren gemäß Anspruch 15,
dadurch gekennzeichnet, daß der Koeffizient $\beta$ als Funktion des Signal/Rausch-Verhältnisses des Übertragungskanals variiert.

17. Verfahren gemäß einem der Ansprüche 8 bis 16,
dadurch gekennzeichnet, daß der erste Dekodierschritt (43) von einem Schritt (411) gefolgt wird, bei dem der Schätzwert $((Z)_p)$ vom ersten dekodierten Wert (45) subtrahiert wird.

18. Verfahren gemäß einem der Ansprüche 8 bis 17,
dadurch gekennzeichnet, daß der oder die Dekodierschritt(e) (43, 48) Dekodieralgorithmen mit höchster Wahrscheinlichkeit anwenden, von der Art des Viterbi-Algorithmus mit gewichteten Entscheidungen.

19. Verfahren gemäß einem der Ansprüche 8 bis 18,
dadurch gekennzeichnet, daß es einen Schritt (42) zum Demultiplexieren umfaßt, das die empfangenen Daten

$((Y_1)_p)$, $((Y_2)_p)$ zu den richtigen Dekodierschritten (43, 48) hinlenkt und welches Nullwerte zu den Dekodierschritten (43, 48) überträgt, für die keine kodierte Daten übertragen wurden.

**20.** Dekodiermodul,
dadurch gekennzeichnet, daß es mindestens zwei Eingänge $((X)_p, (Y)_p, (Z)_p)$ umfaßt, die mindestens einem empfangenen Wert $((X)_p, (Y)_p)$ und mindestens einem geschätzten Wert $((Z)_p)$ entsprechen sowie mindestens zwei Ausgänge $((Z)_{p+1}, (S)_p)$ umfaßt, welche mindestens einem dekodierten Wert $((S)_p)$ und mindestens einem geschätzten Wert $((Z)_{p+1})$ entsprechen und außerdem:

- Mittel (41) zum Summieren der dem empfangenen Wert $((X)_p)$ entsprechenden eingegebenen Werte mit dem geschätzten Wert $((Z)_p)$;

- erste Mittel (43) zum Dekodieren der kodierten Daten $((X)_p, (Y_1)_p)$ gemäß einer ersten faltenden Kodierung, wobei die Daten $((X_1)_p)$, die sich aus den Summierungsmitteln (41) ergeben, berücksichtigt werden;

- erste Mittel (47) zur Verschachtelung der Daten, die sich aus den ersten Dekodiermitteln (43) ergeben;

- zweite Mittel (48) zum Dekodieren der kodierten Daten $((X_2)_p, (Y_2)_p)$ gemäß einer zweiten, redundanten Kodierung;

- Mittel (50) zum Schätzen der Größe des empfangenen Wertes oder der empfangenen Daten $((X)_p)$;

- Mittel (52) zum Entschachteln der Daten $((Z)_p)$, die sich aus den Schätzmitteln (50) ergeben;

- Mittel (49) zum Entschachteln der Daten $((X_3)_p)$, die sich aus den zweiten Dekodiermitteln (48) ergeben und welche dekodierte Daten $((S)_p)$ in ihrer ursprünglichen Reihenfolge erzeugen;

- Verzögerungsmittel (51, 53, 54), welche die Latenz der Dekodiermittel (43, 48), der Verschachtelungsmittel (47) und der Entschachtelungsmittel (49, 52) kompensieren sollen, damit die Gesamtheit der Daten $((X)_p, (Z)_p, (S)_p, (Y)_p)$, die aus diesem Modul kommen, demselben Empfangsaugenblick entsprechen.

**21.** Modul gemäß Anspruch 20,
dadurch gekennzeichnet, daß er in Reihe mit mindestens einem identischen Modul $(31_{p+1})$ geschaltet werden kann.

**22.** Dekodiervorrichtung für digitale Daten,
dadurch gekennzeichnet, daß sie mindestens ein Modul $(31_p)$ gemäß einem der Ansprüche 20 oder 21 umfaßt.

**Claims**

**1.** Method for the error-correction coding of source digital data elements (d), characterized in that it implements in parallel at least two independent steps (11, 13) of systematic convolutional coding, each of said coding steps (11, 13) taking account of all of said source data elements (d),
and in that it comprises at least one step (12) for the temporal interleaving of said source data elements (d), modifying the order in which said source data elements (d) are taken into account between said coding steps (11, 13).

**2.** Method according to Claim 1, characterized in that it comprises a step (15) for the systematic elimination, at predetermined instants of transmission, of at least one coded data element $(Y_1, Y_2)$ produced by at least one of said coding steps (11, 13).

**3.** Method according to Claim 2, characterized in that said elimination step (15) consists of a periodic switching between said coding steps (11, 13), providing, at each transmission instant, for the selection of a single coded data element (Y) from among the set of data elements $(Y_1, Y_2)$ coded by each of said coding steps (11, 13).

**4.** Method according to any one of Claims 1 to 3, characterized in that each of said temporal interleaving steps (12) is followed by a delay step (14),

said temporal interleaving step (12) taking account of the source data elements (d) in the order in which said source data elements (d) feed a first coding step (11) and restoring them in a different order to feed a second coding step (13),

said delay step (14) assigning, to each of said source data elements (d) coming from said temporal interleaving step (12), a delay equal to the latency of decoding of the data elements $(Y_1)$ coded by said first coding step (11).

5. Method according to any one of Claims 1 to 4, characterized in that said temporal interleaving step (12) implements at least one interleaving matrix in which said source data elements (d) are written in successive rows (and columns respectively) and read in successive columns (and rows respectively).

6. Method according to Claim 5, characterized in that, at writing, the increment between two rows (and columns respectively) and/or, at reading, the increment between two columns (and rows respectively) is strictly greater than 1.

7. Method according to Claim 6, characterized in that said increment between two rows (and columns respectively) is a function of the position of the column (or row respectively) during writing (or reading respectively).

8. Method for the coding and decoding of digital data elements $((X)_p, (Y_1)_p, (Y_2)_p)$ in which the coding is carried out according to the method of Claim 1 and in which the decoding is iterative and comprises the following steps:

   - determination of an intermediate data element $((X_1)_p)$ obtained by combination of a received data element with, for the first iteration, a predetermined value and, for the following iterations, with a data element $((Z)_p)$ estimated during the preceding iterations,
   - first decoding (43) according to the first convolutional coding, as a function of at least one of said intermediate data elements $((X_1)_p)$ and of at least one coded data element $((Y_1)_p)$ produced by said first coding step (11), producing a first decoded data element (45),
   - temporal interleaving (47) identical to said interleaving step (12) of the coding method of said first decoded data elements (45), producing first decoded and de-interleaved data elements $((X_2)_p)$,
   - second decoding (48) according to the second convolutional coding, as a function of at least one of said first decoded and de-interleaved data elements $((X_2)_p)$ and of at least one coded data element $((Y_2)_p)$ produced by said second coding step (13), producing a second decoded data element $((X_3)_p)$,
   - estimation (50) of the received source data element $((X)_p)$, as a function of at least one of said first and second decoded data elements $((X_2)_p, (X_3)_p)$, producing an estimated data element $((Z)_{p+1})$,
   - de-interleaving (52) symmetrical to said interleaving step (47), of said estimated data elements $((Z)_{p+1})$.

9. Method according to Claim 8, characterized in that it implements an iterative decoding procedure comprising:

   - a step (43, 48) for the decoding of an intermediate data element $((X_1)_p)$ representing a received data element $((X)_p)$, producing a decoded data element $((X_3)_p)$, and
   - a step (50) for the estimation of said received data element $((X)_p)$ by means of said decoded data element $((X_3)_p)$, producing an estimated data element $((Z)_p)$,

   and in that said intermediate data element $((X_1)_p)$ is obtained, for the first iteration, by a combination (41) of said received data element $((X)_p)$ with a predetermined value, and, for the following iterations, by a combination of said received data element $((X)_p)$ with at least one of said data elements $((Z)_p)$ estimated during the preceding iterations.

10. Method according to Claim 9, characterized in that said estimation step assigns said estimated data element $((Z)_p)$ an additive noise decorrelated from the noise assigned to said received data element $((X)_p)$.

11. Method according to either one of Claims 9 and 10, characterized in that said predetermined value is neutral, and in that said combinations (41) are, for iterations other than the first one, summations of said received data element $((X)_p)$ and of the last estimated data element $((Z)_p)$.

12. Method according to any one of Claims 8 to 11, of the type applied to the decoding of data elements coded according to a method that carries out the joint transmission of the source data elements $((X)_p)$ and of coded redundancy data elements $((Y_1)_p, (Y_2)_p)$, characterized in that said decoding step takes account of all the received data elements, source data elements $((X)_p)$ coded data elements $((Y_1)_p, (Y_2)_p)$, and in that said estimation step is applied solely to the estimation of said source data elements $((X)_p)$.

13. Method according to any one of Claims 8 to 12, characterized in that said estimation step (50) consists in determining the variable $(d_2 \times (X_1)-(X_2))/d_2-1)$, where:

- $d_2$ is the free distance of said second redundant coding:
- $(X_1)$ and $(X_2)$ are the data elements decoded by said first (43) and second (48) decoding steps.

14. Method according to any one of Claims 8 to 13, characterized in that said estimation step (50) is followed, before said de-interleaving step (52), by a logarithmic compression step.

15. Method according to any one of Claims 8 to 14, characterized in that said first decoding step (43) is followed by a step (44) for the multiplication of said first decoded data element (45) by a coefficient $\beta$ that is strictly greater than 1.

16. Method according to Claim 15, characterized in that said coefficient $\beta$ is variable as a function of the signal-to-noise ratio of the transmission channel.

17. Method according to any one of Claims 8 to 16, characterized in that said first decoding step (43) is followed by a step (411) for the subtraction, from said first decoded data element (45), of said estimated data element $((Z)_p)$.

18. Method according to any one of Claims 8 to 17, characterized in that said decoding steps (43, 48) implement maximum likelihood decoding algorithms of the Viterbi algorithm type with weighted decisions.

19. Method according to any one of Claims 8 to 18, characterized in that it comprises a demultiplexing step (42) directing the received coded data elements $((Y_1)_p, (Y_2)_p)$ towards said appropriate decoding steps (43, 48) and transmitting zero values at the decoding steps (43, 48) for which no coded data element has been transmitted.

20. Decoding module, characterized in that it comprises at least two inputs $((X)_p, (Y)_p, (Z)_p)$ corresponding to at least one received data element $((X)_p, (Y)_p)$ and to at least one estimated data element $((Z)_p)$ and at least two outputs $((Z)_{p+1}, (S)_p)$ corresponding to at least one decoded data element $((S)_p)$ and at least one estimated data element $((Z)_{p+1})$, and:

- means (41) for the summation of the inputs corresponding to said received data element $((X)_p)$ and to said estimated data element $((Z)_p)$;
- first means (43) for the decoding of data elements $((X)_p, (Y_1)_p)$ coded according to a first convolutional coding, taking account of the data elements $((X_1)_p)$ coming from said summation means (41);
- first means (47) for the interleaving of the data elements coming from said first decoding means (43);
- second means (48) for the decoding of data elements $((X_2)_p, (Y_2)_p)$ coded according to a second redundant coding;
- means (50) for the estimation of said received data element(s) $((X)_p)$;
- means (52) for the de-interleaving of the data elements $((Z)_p)$ coming from said estimation means (50);
- means (49) for the de-interleaving of the data elements $((X_3)_p)$ coming from said second decoding means (48), delivering the data elements $((S)_p)$ decoded in their original order;
- delay means (51, 53, 54) intended to compensate for the latencies of the decoding means (43, 48), interleaving means (47) and de-interleaving means (49, 52) so that all the data elements $((X)_p, (Z)_p, (S)_p, (Y)_p)$ coming from said module correspond to one and the same instant of reception.

21. Module according to Claim 20, characterized in that it is capable of being cascaded with at least one other identical module $(31_{p+1})$.

22. Decoder of digital data elements, characterized in that it comprises at least one module $(31_p)$ according to either one of Claims 20 and 21.

Fig. 1

Fig. 2

Fig. 3

Fig. 4

EP 0 511 141 B1

19

Fig. 5

Fig. 6

dk ────────────────────────────────────► Xk

ak

ak-1

ak-2

82

82A

82B

83

81

Yk

<u>Fig. 7</u>